# EUROPÄISCHE PATENTSCHRIFT

(11) **EP 0 805 467 B1**
(45) Veröffentlichungstag und Bekanntmachung des Hinweises auf die Patenterteilung: **20.07.2005**
(21) Anmeldenummer: 97107068.5
(22) Anmeldetag: 29.04.1997
(51) Int. Cl.: H01H 19/02, H01H 19/58

(54) **Schalter, insbesondere Drehschalter**
Switch particularly a rotary switch
Interrupteur en particulier interrupteur rotatif

(30) Priorität: 29.04.1996 DE 19617164
(43) Veröffentlichungstag der Anmeldung: 05.11.1997
(73) Patentinhaber: BSH Bosch und Siemens Hausgeräte GmbH, 81739 München (DE)
(72) Erfinder: Puchta, Ralf, Dipl.-Ing., 93053 Regensburg (DE); Plankl, Manfred, 83301 Traunreut (DE); Ulmer, Michael, 83301 Traunreut (DE); Lappat, Hans, 84518 Garching (DE); Seehuber, Hans, 83324 Ruhpolding (DE); Huber, Ernst, 83308 Trostberg (DE); Bally, Ingo, 84529 Tittmoning (DE)

(56) Entgegenhaltungen:
- DE-A- 2 806 713
- DE-A- 3 401 247
- FR-A- 2 441 312

## Beschreibung

Die Erfindung bezieht sich auf einen Drehschalter, gemäß Anspruch 1.

Mit derartigen Drehschaltern werden insbesondere verschiedene Betriebsarten einer Backofensteuerung angewählt und Befehle in Form von den jeweils eingestellten Betriebsarten entsprechend codierten elektrischen Signal-Mustern an eine elektronische Steuer- bzw. Regelschaltung, z.B. in Form eines Mikrocontrollers, weitergegeben. Die codierten Signal-Muster werden dabei mittels eines entsprechend den verschiedenen Schalterstellungen verstellbaren Kontaktbrücken-Schleifers generiert, der den Betriebsarten entsprechend mit Kontakt-Schleifflächen codierte, vorzugsweise auf einer Kontaktscheibe aufgebrachte, Kontaktbahnen beschleift. Ein derartiger Drehschalter ist z.B in DE 34 01 247 A offenbart.

Es ist Aufgabe vorliegender Erfindung, den Aufwand zur Herstellung von Schaltern der vorgenannten Art, insbesondere in Form von Einbau-Drehschaltern, zum Einsatz für eine Fertigung mit verschiedenen Schaltervarianten mit jeweils pro gesamtem Schalterbetätigungsweg unterschiedllicher Zahl und unterschiedlicher Verteilung von Schaltereinstellungen entsprechend der Zahl der jeweils anzuwählenden Betriebsarten reduzieren zu können.

Die Lösung dieser Aufgabe gelingt durch einen Schalter gemäß Anspruch 1; vorteilhafte Ausgestaltungen der Erfindung sind jeweils Gegenstand der Unteransprüche.

Der erfindungsgemäße Schalter erlaubt aufgrund seiner Universal-Codier-Kontaktscheibe die Beschränkung auf ein Einheitsbauteil trotz mehrerer Schaltervarianten mit jeweils unterschiedlicher Zahl und unterschiedlicher Verteilung von einzustellenden Betriebsarten über einen vorgegebenen Schalterbetätigungsweg, wobei insbesondere bei einem Drehschalter mit konzentrisch zur Drehwelle des Kontaktbrücken-Schleifers angeordneten codierten Kontaktbahnen die aufeinanderfolgenden zur Codierung des Signal-Musters vorgesehenen Schleiferstellungen vorteilhaft über den gesamten 360°-Drehumfang derart nichtlinear verteilt sind, daß sich für sämtliche vorgesehenen Schaltervarianten eine jeweils lineare Verteilung der Betriebsarten und auch des Kontaktbrücken-Schleifers über den gesamten 360°-Drehumfang je Schaltervariante erreichen läßt.

Die Erfindung sowie weitere vorteilhafte Ausgestaltungen der Erfindung gemäß Merkmalen der Unteransprüche werden im folgenden anhand schematisch dargestellter Ausführungsbeispiele in der Zeichnung näher erläutert; darin zeigen:
- FIG 1,2: die Draufsicht auf jeweils einen Betriebsarten-Schalter für eine Backofensteuerung mit einer ersten Schaltervariante mit vier Betriebsarten und einer zweiten Schaltervariante mit sechs Betriebsarten;
- FIG 3: in einer perspektivischen Explosionsdarstellung eine Bedieneinheit für eine Backofensteuerung mit einem Betriebsartenschalter und einem Temperaturschalter;
- FIG 4: die axiale Draufsicht auf ein Fixierteil-Modul;
- FIG 5: den Raststern und den Rastnocken des Fixierteil-Moduls gemäß FIG 4;
- FIG 6: die Draufsicht auf eine Universal-Codier-Kontaktscheibe mit fünf codierten Kontaktbahnen und maximal zweiundzwanzig über den Umfang verteilten Einstell-Endlagen für den Schalter und damit den Kontaktbrücken-Schleifer;
- FIG 7: eine Binär-Codierung für die Universal-Codier-Kontaktscheibe gemäß FIG 6 mit zweiundzwanzig Einzel-Winkelstellungen und Schaltervarianten zwischen jeweils zwei bis acht Betriebsarten.

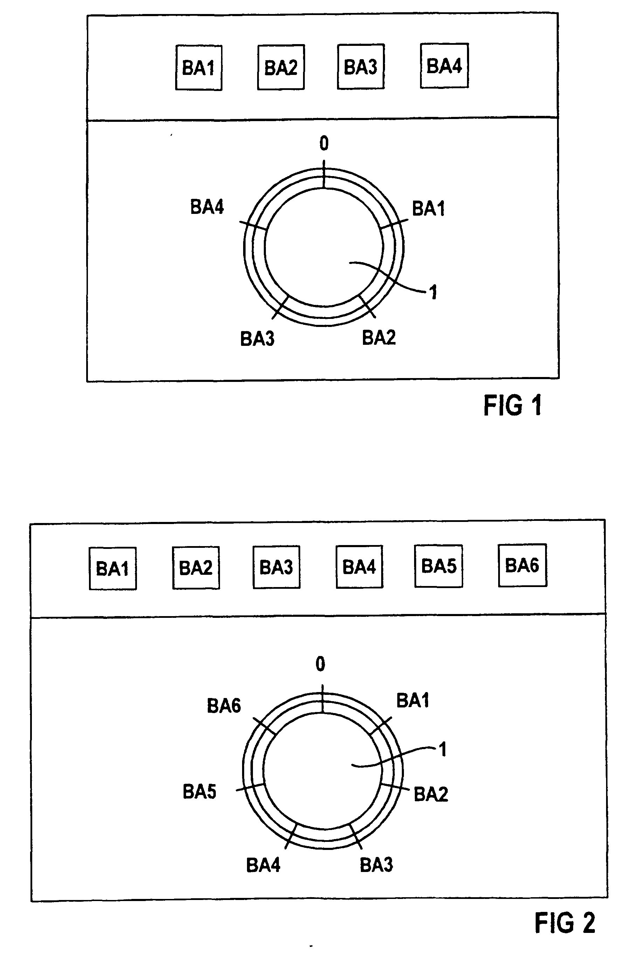

FIG 1,2 zeigen jeweils die Draufsicht auf die Bedienfront einer Backofensteuerung mit einem durch Drehen in unterschiedliche Betriebsarten stellbaren Bedienteil 1 und oberhalb des Bedienteils 1 angeordneten Anzeigen für die jeweils eingestellte Betriebsart. Das Bedienteil 1 gemäß FIG 1 weist neben der Neutralstellung vier über den Umfang verteilte Einstellungen von Betriebsarten BA1-BA4 und das Bedienteil 1 gemäß FIG 2 weist neben einer Neutralstellung sechs über den Umfang verteilte Einstellungen von Betriebsarten BA1-BA6 auf.

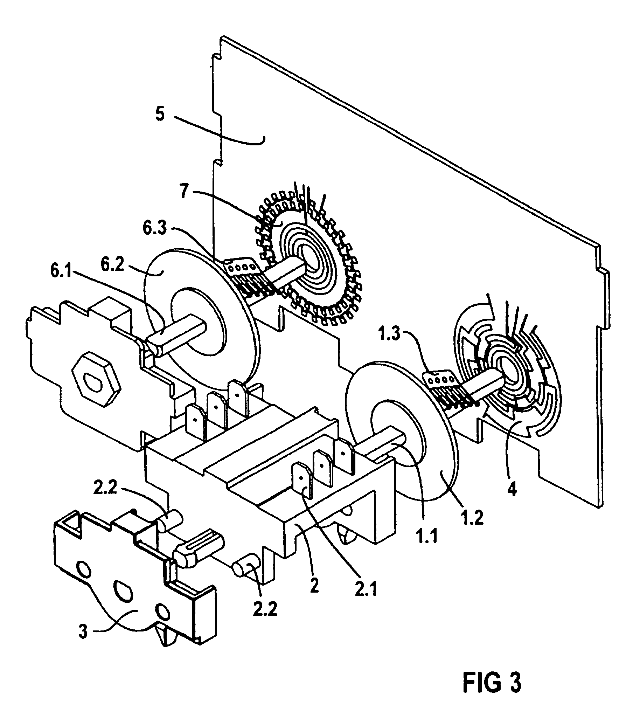

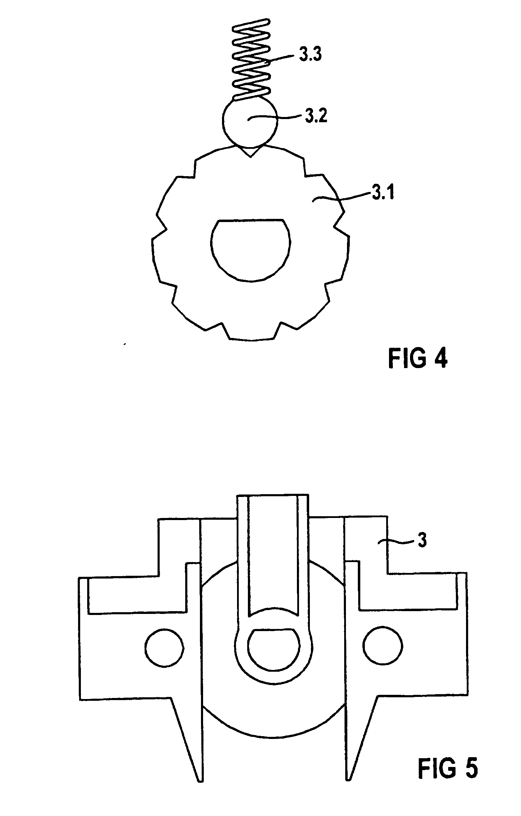

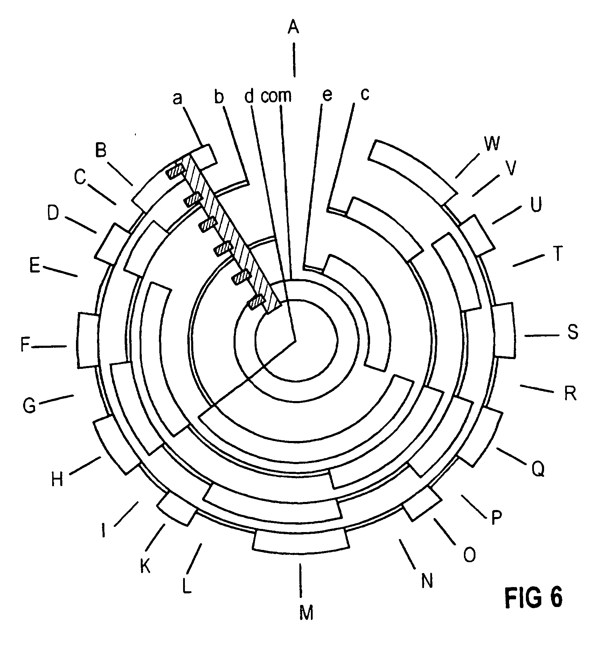

FIG 3 zeigt in perspektivischer Explosionsdarstellung einen Betriebsartenschalter mit einer in einem Grundkörper 2 gelagerten Drehwelle 1.1, auf deren rechtes, durch eine Öffnung einer hinter der Bedienfront angeordneten Leiterplatte 5 ragendes Ende in hier nicht näher dargestellter Weise das Bedienteil 1 gemäß FIG 1,2 formschlüssig aufsteckbar ist. Auf den Grundkörper 2 ist an seinem linken Ende - z.B. in vorteilhafter Weise mittels axialer Aufsteckzapfen 2.2 - ein in FIG 4,5 näher dargestelltes Fixierteil 3 als Modul aufsteckbar, wobei das linke hintere Ende der Drehwelle 1.1 in eine entsprechende formschlüssige Mitnahme eines in dem Fixierteil 3 drehbar angeordneten Raststernes 3.1 hineinragt. Die jeweilige Raststellung des Raststernes 3.1 und damit die Fixierung des Bedienteils 1 in einer der eingestellten Betriebsarten wird mittels eines durch radialen Druck einer Rastfeder 3.3 in die Kerben des Raststernes 3.1 eingedrückten Rastnockens 3.2 sichergestellt. Der Grundkörper 2 weist Kontaktzungen 2.1 für den Anschluß einer Netzzuleitung auf, die durch einen unterhalb der Kontaktzungen liegenden Walzenschalter zu- bzw. abschaltbar ist.

In vorteilhafter Weise ist der Grundkörper 2 einschließlich seiner darin gelagerten Drehwelle 1.1 des Schalters als Universalbauteil unabhängig von unterschiedlichen Schaltervarianten verwendbar, da die Berücksichtung unterschiedlicher Schaltervarianten lediglich durch die Änderung des Raststernes 3.1 durch Aufstecken eines entsprechend angepaßten Fixierteils 3 erfolgen kann.

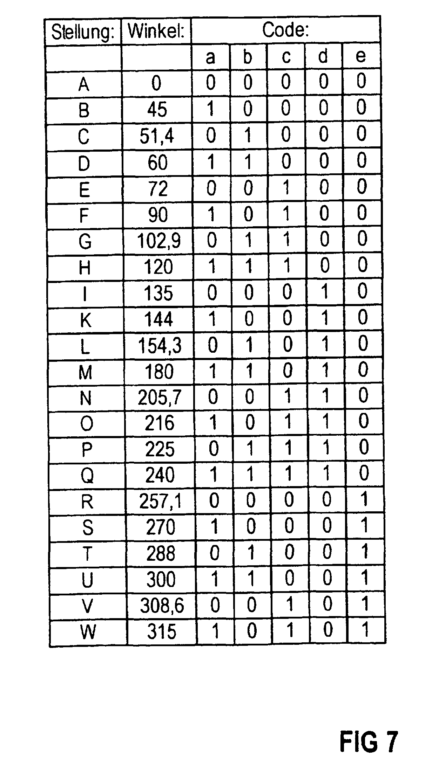

Die erfolgreiche Vereinheitlichung durch Verwendung universell einsetzbarer Bauteile trotz Abdeckung einer Schalterfabrikation mit unterschiedlichen Schaltervarianten kann hinsichtlich einer korrespondierenden elektrischen bzw. elektronischen Signalweitergabe an eine nachfolgende Steuerung, insbesondere in Form eines Mikrocontrollers, dadurch noch weiter verbessert werden, daß - wie insbesondere aus FIG 6,7 ersichtlich - in Abhängigkeit von der Einstellbetätigung des Schalters, insbesondere in Abhängigkeit von der Stellung der Drehwelle 1.1 eines zur Einstellung vorgesehenen Drehschalters, ein Kontaktgeber 1.2;1.3 in Form eines drehschlüssig auf die Drehwelle 1.1 aufsteckbaren Mitnahmeteils 1.2 mit einem daran befestigten Kontaktbrücken-Schleifer 1.3 Kontaktbahnen a-e einer Universal-Codier-Kontaktscheibe 4 beschleift, deren Kontakt-Schleifflächen zu dem Kontaktbrücken-Schleifer 1.3 derart codiert sind, daß sich entsprechend den maximal hier angenommenen zweiundzwanzig Einzel-Winkelstellungen A-W jeweils ein spezifisch codiertes Signal-Muster durch Kontaktgabe zwischen den einzelnen Kontakt-Schleifflächen über den Kontaktbrücken-Schleifer 1.3 an den Ausgängen der Kontaktbahnen a-e ergeben, die an Eingangspins einer nachfolgenden elektronischen Steuerung anschließbar sind; die je Kontaktbahn untereinander elektrisch verbundenen Kontakt-Schleifflächen werden zur Generierung der Singal-Muster über den Kontaktbrücken-Schleifer 1.3 an ein Potential gelegt, das an eine über den gesamten Umfang verlaufende Kontakt-Schleiffläche einer inneren, ebenfalls von dem Kontaktbrücken-Schleifer 1.1 beschliffenen Kontaktbahn angeschlossen ist.

FIG 7 erläutert das Codierprogramm der in FIG 6 dargestellten Universal-Codier-Kontaktscheibe 4 mit maximal zweiundzwanzig Winkelstellungen des Kontaktbrücken-Schleifers 1.3. Dabei bedeuten die Großbuchstaben der Tabelle jeweils die einzelnen Winkelstellungen A-W des Kontaktbrücken-Schleifers 1.3 und kennzeichnen die Kleinbuchstaben a-e die codierte Verteilung der Kontakt-Schleifflächen bzw. Potentialbelegungen und somit die Signal-Muster der an die Prozessor-Pins jeweils angeschlossenen Kontaktbahnen. Die zweiundzwanzig unterschiedlichen Codierungen sind über den gesamten Umfang der Universal-Codier-Kontaktscheibe 4 nichtlinear über 360° verteilt, derart daß sich für hier vorgesehene Schaltervarianten von zwei bis zu acht Betriebsarten vorteilhaft eine jeweils lineare Verteilung der Betriebsarten je Schaltervariante erreichen läßt.

Die Entscheidung, welche Winkelstellung dann welcher Funktion gemäß einer Betriebsart entsprechen soll, wird dem an die Prozessor-Pins angeschlossenen Mikrocontroller über einen Speicher, insbesondere einen nichtflüchtigen EEPROM, mitgeteilt. Dadurch können nicht nur mit einem Einheitsbauteil verschiedene Schaltervarianten in einer Fertigung abgedeckt werden, sondern auch spätere Verbesserungen, wie z.B. das Vertauschen der Schalterfunktionen aus Design- oder Ergonomiegründen, ohne zusätzlichen Entwicklungs- und Fertigungsaufwand lediglich durch Umprogrammierung des EEPROM realisiert werden.

In fertigungstechnisch besonders aufwandsarmer Weise ist, wie aus FIG 3 ersichtlich, die Codier-Kontaktscheibe 4 integraler Bestandteil einer Leiterplatte 5, die vorzugsweise hinter der Bedienfront gemäß FIG 1-2 angebracht und mit einem Durchgang zum Aufstecken des Bedienteils 1 auf die bis an die Vorderseite der Bedienfront reichende Drehwelle 1.1 versehen ist.

Gemäß einer weiteren Ausgestaltung ist, wie ebenfalls aus FIG 3 ersichtlich, mit der die Codier-Kontaktscheibe 4 integrierenden Leiterplatte 5 eine weitere Kontaktscheibe 7 zur Impulsgabe für einen seriellen Temperatursteller 6 des Backofens integriert, der ebenfalls durch Drehen einer Drehwelle 6.1 mit darauf formschlüssig gehaltenem Kontaktgeber 6.2;6.3 betätigbar ist.

## Patentansprüche

1. Drehschalter (1) mit entsprechend spezifischen Schalterstellungen (BA1-BA4 bzw. BA1-BA6) codierten ausgangsseitigen elektrischen Signal-Mustern in Abhängigkeit von je Schalterstellung spezifischer Kontaktgabe zwischen einem Kontaktbrücken-Schleifer (1 3) einerseits und codierten Kontaktbahnen (a-e) einer Universal-Codier-Kontaktscheibe (4) andererseits mit je Winkelstellung des Kontaktbrucken-Schleifers (1.3) unterschiedlicher Kontaktbahn-Codierung entsprechend samtlichen abzudeckenden unterschiedlichen Schaltervarianten, **dadurch gekennzeichnet, dass** er mit uber den Umfang der Universal-Codier-Kontaktscheibe (4) nichtlinear verteilten unterschiedlichen Codierstellungen und über den Umfang der Universal-Codier-Kontaktscheibe (4) linear verteilten, jeweils den Schalterstellungen einer Schaltervanante entsprechenden Schleiferstellungen mit jeweils spezifischer Codierung ausgestattet ist.

2. Drehschalter (1) nach Anspruch 1, **dadurch gekennzeichnet, dass** er mit zu seiner Drehwelle (1.1) konzentnschen Kontaktbahnen (a-e) sowie mit einem zu der Drehwelle (1 1) drehbaren Kontaktbrücken-Schleifer (1 3) ausgestattet ist

3. Drehschalter (1) nach Anspruch 2, **dadurch gekennzeichnet, dass** er mit einem axial mittelbar bzw. unmittelbar auf die Drehwelle (1.1) des Drehschalters (1) aufgesteckten Kontaktbrücken-Schleifer (1.3) ausgestattet ist.

4. Drehschalter (1) nach einem der vorhergehenden Ansprüche, **dadurch gekennzeichnet, dass** er mit einer Binär-Codierung der vom Kontaktbrücken-Schleifer (1 3) beschliffenen Kontakt-Schleifflächen der Kontaktbahnen (a-e) auf der Universal-Codier-Kontaktscheibe (4) ausgestattet ist

5. Drehschalter (1) nach zumindest einem der vorhergehenden Ansprüche, **dadurch gekennzeichnet, dass** er einen Anschluß der Kontaktbahnen (a-e) an die Eingangspins eines Prozessors, insbesondere eines Mikrocontrollers, aufweist.

6. Drehschalter (1) nach zumindest einem der vorhergehenden Ansprüche, **dadurch gekennzeichnet, dass** eine Zuordnung der codierten Signal-Muster zu bestimmten Schalterstellungen (BA1-BA4 bzw.BA1-BA6 bzw.A-W) des Schalters durch ein Speicherelement, insbesondere durch ein nichtflüchtiges EEPROM, besteht.

7. Drehschalter (1)nach zumindest einem der vorhergehenden Ansprüche, **dadurch gekennzeichnet, dass** der Drehschalter (1) mit einem die Schalterstellungen jeweils sichernden Fixierteil (3), insbesondere einem Rast-Fixierteil, ausgestattet ist.

8. Drehschalter (1) nach zumindest einem der vorhergehenden Ansprüche, **dadurch gekennzeichnet, dass** die Universal-Codier-Kontaktscheibe (4) integrierter Bestandteil einer Leiterplatte (5) ist.

9. Drehschalter (1) nach dem vorhergehenden Anspruch, **dadurch gekennzeichnet, dass** eine weitere Kontaktscheibe (7), insbesondere eine Impulsgeber-Kontaktscheibe für einen Temperatur-Schalter, vorhanden ist.

10. Serien von Drehschaltern (1), insbesondere Betriebsschaltern, nach zumindest einem der vorhergehenden Ansprüche mit zueinander, hinsichtlich Anzahl und Umfangsverteilung, unterschiedlichen Schalterkonfigurationen (BA1-BA4 bzw. BA1-BA6) entsprechend verschiedenen Schaltervarianten, **dadurch gekennzeichnet, dass** jeder der Drehschalter mit einer gleichen Universal-Codier-Kontaktscheibe (4) ausgestattet ist, und dass die Universal-Codier-Kontaktscheibe (4) über ihren Umfang nichtlinear verteilte unterschiedliche Codierstellungen und für jede der verschiedenen Schaltervarianten über ihren Umfang hnear verteilte, jeweils den Schalterstellungen der Schaltervariante entsprechende Schleiferstellungen mit jeweils spezifischer Codierung aufweist.

## Claims

1. Rotary switch (1) with output electrical signal patterns, which are coded in correspondence with specific switch settings (BA1-BA4 or BA1-BA6), in dependence on contact-making, which is specific to each switch setting, between a contact bridge wiper (1.3) on the one hand and coded contact tracks (a-e) of a universal coding contact disc (4) on the other hand with contact track coding, which is different for each angular setting of the contact bridge wiper (1 3), corresponding with all different switch variants to be covered, **characterised in that** it is equipped with different code settings non-linearly distributed over the circumference of the universal coding contact disc (4) and with wiper settings, which are linearly distributed over the circumference of the universal coding contact disc (4) and which respectively correspond with the switch settings of a switch variant, with respective specific coding.

2. Rotary switch (1) according to claim 1, charactensed in that it is equipped with contact tracks (a-e) concentric with its rotary shaft (1.1) as well as with a contact bridge wiper (1 3) rotatable relative to the rotary shaft (1 1)

3. Rotary switch (1) according to claim 2, **characterised in that** it is equipped with a contact bridge wiper (1 3) axially plugged indirectly or directly onto the rotary shaft (1.1) of the rotary switch (1).

4. Rotary switch (1) according to one of the preceding claims, charactensed in that it is equipped with a binary coding of the contact wiping surfaces, which are wiped by the contact bridge wiper (1 3), of the contact tracks (a-e) on the universal coding contact disc (4).

5. Rotary switch (1) according to at least one of the preceding claims, charactensed in that it has a connection of the contact tracks (a-e) with the input pins of a processor, particularly a microcontroller.

6. Rotary switch (1) according to at least one of the preceding claims, **characterised in that** an association of the coded signal pattern with specific switch settings (BA1-BA4 or BA1-BA6 or A-W) of the switch exists via a memory element, particularly via a non-volatile EEPROM.

7. Rotary switch (1) according to at least one of the preceding claims, charactensed in that the rotary switch (1) is equipped with a fixing part (3), particularly a detent fixing part, securing each of the switch settings.

8. Rotary switch (1) according to at least one of the preceding claims, **characterised in that** the universal coding contact disc (4) is an integrated component of a circuitboard (5).

9. Rotary switch (1) according to the preceding claim, **characterised in that** a further contact disc (7), particularly a pulse transmitter contact disc for a temperature switch, is present.

10. Series of rotary switches (1), particularly operating switches, according to at least one of the preceding claims with different switch variants corresponding with switch configurations (BA1-BA4 or BA1-BA6) differing from one another with respect to number and circumferential distribution, **characterised in that** each of the rotary switches is equipped with the same universal coding contact disc (4) and that the universal coding contact disc (4) has different coding settings non-linearly distributed over its circumference and, for each of the different switch variants, wiper settings, which are linearly distributed over its circumference and which respectively correspond with the switch settings of the switch variant, with respective specific coding.

## Revendications

1. Commutateur rotatif (1) comprenant des modèles de signaux électriques codés, du côté sortie, correspondant à des positions spécifiques (BA1-BA4 resp. BA1-BA6) du commutateur, en fonction d'un contact, spécifique à chaque position du commutateur, entre un frotteur de pont de contact (1.3), d'une part, et des bandes de contact codées (a-e) d'un disque de contact à codage universel (4), d'autre part, ayant un codage de la bande de contact différent pour chaque position angulaire du frotteur du pont de contact (1.3), correspondant à toutes les différentes variantes de commutateur à couvrir, **caractérisé en ce qu'**il est équipé de positions de codage différentes, réparties de manière non linéaire sur le pourtour du disque de contact à codage universel (4) et de positions du frotteur correspondant respectivement aux positions du commutateur d'une variante du commutateur, réparties de manière linéaire sur le pourtour du disque de contact à codage universel (4), ayant chacune un codage spécifique.

2. Commutateur rotatif (1) selon la revendication 1, **caractérisé en ce qu'**il est muni de bandes de contact (a-e) concentriques par rapport à son arbre de rotation (1 1) ainsi que d'un frotteur de pont de contact (1.3) rotatif par rapport à l'arbre de rotation (1 1).

3. Commutateur rotatif (1) selon la revendication 2, **caractérisé en ce qu'**il est muni d'un frotteur de pont de contact (1.3) embroché axialement indirectement ou directement sur l'arbre de rotation (1.1) du commutateur rotatif (1).

4. Commutateur rotatif (1) selon l'une quelconque des revendications précédentes, **caractérisé en ce qu'**il est équipé sur le disque de contact à codage universel (4) d'un codage binaire des surfaces de frottement par contact, frottées par le frotteur de pont de contact (1.3), des bandes de contact (a-e).

5. Commutateur rotatif (1) selon au moins l'une quelconque des revendications précédentes, **caractérisé en ce qu'**il présente un raccordement des bandes de contact (a-e) aux broches d'entrée d'un processeur, notamment d'un microcontrôleur.

6. Commutateur rotatif (1) selon au moins l'une quelconque des revendications précédentes, **caractérisé en ce qu'**une affectation des modèles de signaux codés à certaines positions du commutateur (BA1-BA4 resp. BA1-BA6 resp A-W) existe au moyen d'un élément de mémorisation, notamment au moyen d'une mémoire EEPROM non volatile.

7. Commutateur rotatif (1) selon au moins l'une quelconque des revendications précédentes, **caractérisé en ce que** le commutateur rotatif (1) est équipé d'une pièce de fixation (3), notamment d'une pièce de fixation à encliqueter, bloquant respectivement les positions du commutateur.

8. Commutateur rotatif (1) selon au moins l'une quelconque des revendications précédentes, **caractérisé en ce que** le disque de contact à codage universel (4) est une pièce intégrée d'une plaquette à circuit imprimé (5)

9. Commutateur rotatif (1) selon la revendication précédente, **caractérisé en ce qu'**un autre disque de contact (7), notamment un disque de contact d'un générateur d'impulsions, est présent pour un commutateur thermique.

10. Séries de commutateurs rotatifs (1), notamment de commutateurs de service, selon au moins l'une quelconque des revendications précédentes, comprenant des configurations de commutateurs (BA1-BA4 resp. BA1-BA6), différentes les unes par rapport aux autres au regard du nombre et de la répartition sur le pourtour, correspondant à différentes variantes de commutateur, **caractérisé en ce que** chacun des commutateurs rotatifs est équipé d'un disque de contact à codage universel identique (4) et **en ce que** le disque de contact à codage universel (4) présente des positions de codage différentes, réparties de manière non linéaire sur son pourtour, pour chacune des différentes variantes de commutateur, et des positions du frotteur, réparties de manière linéaire sur son pourtour, correspondant respectivement aux positions du commutateur de la variante du commutateur, ayant chacune un codage spécifique
